Europäisches Patentamt

European Patent Office

Office européen des brevets

(11) Publication number:: **0 193 338**

**A2**

(12) **EUROPEAN PATENT APPLICATION**

(21) Application number: **86301149.0**

(22) Date of filing: **19.02.86**

(51) Int. Cl.⁴: **C 23 C 14/22**

(30) Priority: **21.02.85 GB 8504458**

(43) Date of publication of application:
**03.09.86 Bulletin 86/36**

(84) Designated Contracting States:
**CH DE FR GB IT LI NL SE**

(71) Applicant: **GENERAL ENGINEERING RADCLIFFE LIMITED**
**Bury Road**
**Radcliffe Manchester, M26 9UR(GB)**

(72) Inventor: **Nadir, Abdul**
**65 Herristone Road**
**Crumpsall Manchester, M8 6PL(GB)**

(72) Inventor: **Ahmed, Ghassoor**
**65 Herristone Road**
**Crumpsall Manchester, M8 6PL(GB)**

(74) Representative: **Downey, William Gerrard et al,**
**WILSON, GUNN, ELLIS & CO. 41 Royal Exchange Cross Street**
**Manchester M2 7BD(GB)**

(54) **A method of and apparatus for producing multilayered coatings.**

(57) A workpiece 7 is coated in an ion plating vacuum chamber 1 with material. A reactive gas, such as oxygen, is introduced into the chamber and reacts with the basic coating material to form a different coating layer. By varying the introduction of reactive gas, possibly mixed with an inert gas, such as argon, layers of material of differing compositions may be sequentially laid on the workpiece.

FIG.1

EP 0 193 338 A2

-1-

# A METHOD OF AND APPARATUS FOR PRODUCING MULTI-LAYERED COATINGS

The present invention relates to a method of and apparatus for producing Aluminium Oxide, Aluminium Nitride and other types of dielectric coatings have played a vital role in materials technology for decades. In particular, they are continuously used in the microelectronics and optical industries.

The invention is especially concerned with the production of Aluminium/Aluminium Oxide multi-layered coatings, but could well be applied to other dielectrics such as titanium nitride, silicon oxide or nitride and tin oxide.

The high dielectric constant of aluminium oxide and its success in providing radiation resistance as well as its ability to provide corrosion protection and wear resistance in gasifier fabrication, have stimulated many programmes to investigate the most efficient method of producing aluminium oxide films. Although there are many techniques to prepare aluminium oxide films, the ion plating process has been scarcely used to produce such films. This may be due to the fact that aluminium oxide films are good insulators and charge up during the ion plating process.

According to one aspect of the present invention there is provided apparatus for the production of a multilayer coating comprising a housing defining a vacuum chamber, means for supporting a workpiece in the chamber, means for supporting a source of coating material in the chamber and means for introducing gas into the chamber and exhausting gas from the chamber, the means for introducing and exhausting being arranged so that in operation sequential coats of material alone and of material reacted with the gas introduced may be produced.

According to another aspect of the present invention, there is provided a method of producing a multilayer coating on a workpiece including the steps of supporting the workpiece in a vacuum chamber, evacuating the chamber, depositing material from a source onto the workpiece to produce a first coating of material on the workpiece and introducing a gas into the chamber to react with the coating material to produce a second different coating.

By pulsing oxygen or any other reactive gas into the ion plating vacuum chamber during the deposition of metal for example Aluminium, it is possible to deposit multi-layered coating of metal, dielectrics for example Aluminium/Aluminium Oxide.

Thermionically assisted triode discharge is used to support the discharge at low argon base pressure.

If desired, the coat produced from the reacted material may be deposited before the deposition of the material coat.

In a preferred embodiment, the means for supporting the workpiece comprises a water cooled holder. Means may be provided for applying a high d.c. or R.F. negative bias to the holder. The means for introducing and exhausting may comprise a valve for injecting gas and a pumping port through which gas may be removed from the chamber. An inert gas, such as argon, may be introduced with the reactive gas. The reactive gas may, for example, be oxygen. The coating material may be aluminium. The material may be evaporated using resistance heated boats or an electron beam source. Reactive gas flow may be timer controlled.

In order that the invention may be fully understood, one embodiment of the invention will now be described by way of example with reference to the accompanying drawings, in which:-

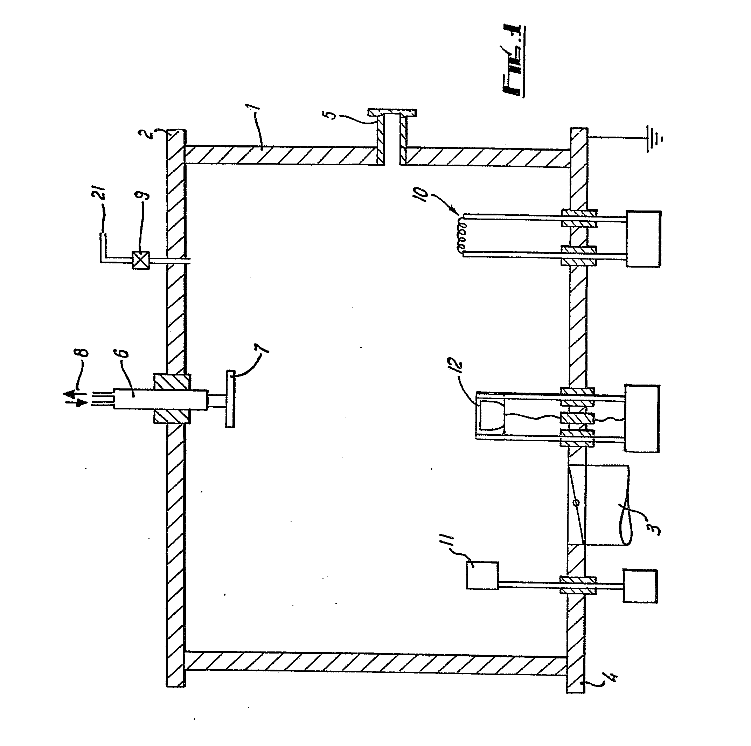

Figure 1 shows ion plating equipment; and

Figure 2 shows a gas mixing and pulsing system for use in conjunction with the ion plating equipment of Figure 1.

Ion plating equipment consists of a steel chamber 1 with a top lid 2 and a pumping port 3 at the base 4. A window 5 is provided on the side wall for viewing. The top lid 2 contains a water cooled holder 6 for holding the workpiece 7. Means are provided for applying a high d.c or R.F.

negative bias to the holder 6.

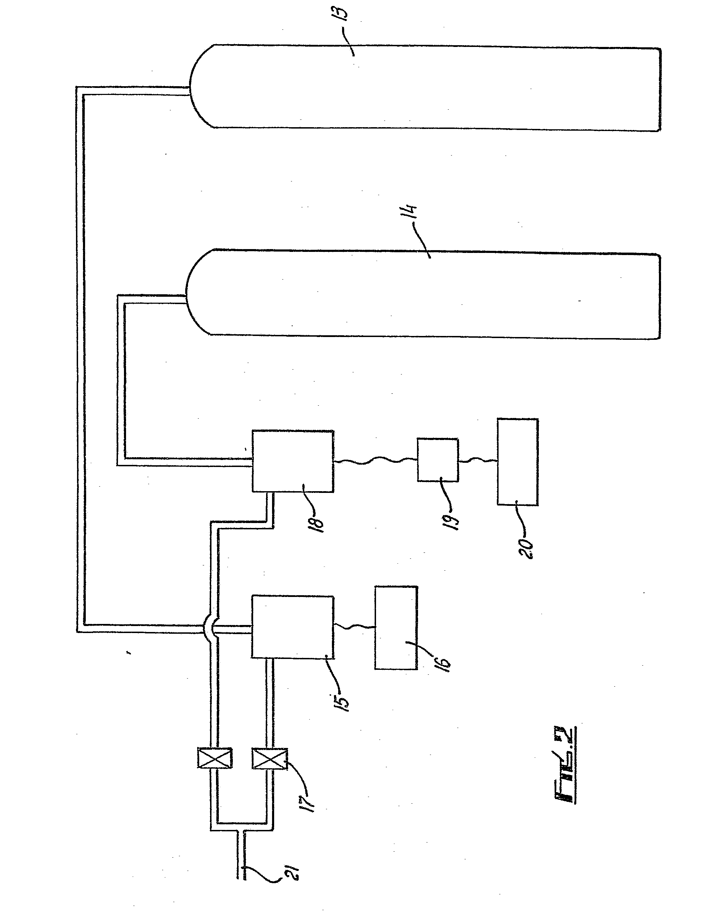

The workpiece is water cooled or heated by means of a coolant or heating system indicated generally at 8. Gas is injected into the chamber via a valve 9 towards the workpiece 7. A gas mixing and pulsing system is illustrated in more detail in Figure 2. The discharge is supported by means of an electron source in the form of a hot wire filament 10 and a positively biased probe 11. Use of an anode and filament combination raises the ionisation efficiency of the system and it is possible to achieve improvements of a factor of about 100 in comparison with conventional ion plating processes. The result of improved ionisation efficiency is increased current density which means the possibility of operating at low argon base pressure that is ($< 1 \times 10^{-3}$ torr) and better coating densification. Evaporation of materials is carried out using resistance heated boats or an electron beam source 12.

Referring to Figure 2 the gas mixing and pulsing system comprises supplies of argon 13 and oxygen or other reactive gas 14. The flow of argon is controlled by an electromagnetic valve 15 which is operated from means 16. A fine needle valve 17 is used to adjust the continuous flow of argon to the chamber 1 via the valve 9. The flow of oxygen is controlled by an electromagnetic valve 18 which in turn is controlled by an adjustable timer 19 powered by means 20. A timer 19 switches the flow of reactive gas on/off at certain intervals. The on or off interval may vary between six seconds and two minutes. The two gases are mixed at junction 21 prior to injecting into the chamber 1 via the valve 9.

In the coating procedure the workpiece 7 is cleaned then clamped to the water cooled holder 6 which ensures that its temperature will not go above 250°C during sputter cleaning and evaporation. The vacuum chamber 1 is pumped down to low pressure for example $1 \times 10^{-5}$ torr then backfilled with argon to a pressure of $1 \times 10^{-2}$ torr. The workpiece is sputtered for 10 minutes at this pressure and at d.c. or R.F. negative bias at 2 KV. At the end of the sputter cleaning process, the argon pressure reduces to $1 \times 10^{-3}$ torr and the oxygen flow is adjusted to the required value. The filament voltage is set to 10V to give full emission current and the probe voltage is raised slowly to a positive bias of 200V. d.c. The discharge is then initiated between the filament 11 and the probe 10. The workpiece bias is increased to the required value and the aluminium or any other metal is evaporated at argon base pressure of ($< 1 \times 10^{-3}$ torr) whilst pulses of oxygen or any other reactive gases are admitted to the chamber at certain intervals for example, 3 sec. on / 60 sec. off depending on the thickness of the multi layered coating required.

The above described apparatus and method enables the following advantages to be achieved.

A highly uniform and adherent metal/dielectric multi layered coating could be deposited to a thickness up to 10 μ or more.

By using a thermionically assisted triode discharge, it is possible to operate at low argon gas base pressure thus making the process more efficient and less expensive in terms of gas consumption.

It is possible to control independently the workpiece negative bias, argon gas pressure, reactive gases pressure and discharge current density.

Different reactive gases can be employed to deposit different layers of for example Aluminium/ Aluminium Oxide/Aluminium Nitride.

Highly dense coatings can be achieved at low argon base pressure and high power density.

Metal, semiconductors or insulators can be coated in this process.

The process can well be controlled by microprocessor and by using sensors such as a coating thickness monitor and mass spectrometer.

Different coating materials can be evaporated using resistance heated boats or an electron beam source.

A DC or RF signal can be applied to the workpiece.

It will be appreciated that the above embodiment has been described by way of example only and that many variations are possible without departing from the scope of the invention.

-8-

## CLAIMS

1.    Apparatus for the production of a multi-layer coating comprising a housing defining a vacuum chamber (1), means (6) for supporting a workpiece in the chamber, means (12) for supporting a source of coating material in the chamber characterised by means (9) for introducing gas into the chamber and exhausting gas from the chamber, the means for introducing and exhausting being arranged so that in operation sequential coats of material alone and of material reacted with the gas introduced may be produced.

2.    Apparatus as claimed in claim 1, in which the means for suporting the workpiece comprises a holder (6) which is disposed to be cooled during operation.

3.    Apparatus as claimed in claim 1 or 2, in which means are provided for applying a d.c. bias to the means (6) for supporting the workpiece.

4.    Apparatus as claimed in claim 1 or 2, in which means are provided for applying an R.F. negative bias to the means (6) for supporting the workpiece.

5. Apparatus as claimed in claim 1 or 2, in which the means for introducing gas into and exhausting as from the chamber, comprises a valve (9) for injecting gas into and a pumping port through which gas may be removed from the chamber.

6. Apparatus as claimed in any preceding claim, in which the means for supporting a source of coating material comprises resistance heated boats (12).

7. Apparatus as claimed in any of claims 1 to 5, in which an electron beam source is provided for evaporating coating material.

8. Apparatus as claimed in any preceding claim, in which the means for introducing gas includes a gas mixing and pulsing system.

9. Apparatus as claimed in claim 8, in which themeans for introducing comprises a needle valve (17) for adjusting the flow of an inert gas, an electromagnetic valve (18) for controlling the flow of a reactive gas, and an adjustable timer for controlling the operation of valve (18).

10. A method of producing a multilayer coating on a workpiece including the steps of supporting the workpiece in a vacuum chamber, depositing material from a source onto the workpiece to produce a first coating of material on the workpiece characterised by introducing a gas into the chamber to react with the coating material to produce a second different coating.

11.   A method as claimed in claim 10, in which a coating of material from the source is deposited before the different coating.

12. A method as claimed in claim 10, in which the second, different, coating is deposted between the coating of material.

13.   A method as claimed in claim 10, 11, or 12, in which an inert gas is introduced with the reactive gas.

14.   A method as claimed in any of claims 10 to 13, in which the reactive gas is turned on/off at certain intervals.

15.   A method as claimed in any of claims 10 to 14, in which the workpiece to be coated is sputter cleaned.

16.   A method as claimed in any of claims 10 to 15, in which the workpiece is subjected to a d.c. or R.F. negative bias.

FIG.1

FIG.2